# EUROPEAN PATENT APPLICATION

(11) **EP 4 465 784 A2**
(43) Date of publication of application: **20.11.2024**
(21) Application number: 24175783.0
(22) Date of filing: 14.05.2024
(51) Int. Cl.: H05K 7/20

(54) **SYSTEMS AND METHODS FOR COMPUTER CABINET COOLING**

(30) Priority: 16.05.2023 US 202363502583 P
(71) Applicant: Vertiv Corporation, Westerville, OH 43082 (US)
(72) Inventor: Rancic , Denis, 10430 Samobor (HR); Pavlovic, Kresimir, 10000 Zagreb (HR); Merkas, Antonio, 49223 Sveti Kriz Zacretje (HR); Denis, Namlic, 10090 Zagreb (HR)
(74) Representative: Bryn-Jacobsen, Caelia

(57) **Abstract**

A system for cooling a computer cabinet can include a computer cabinet having an interior space, two or more vertical rails within the interior space of the cabinet, one or more rackmounted computer modules coupled to the vertical rails, and a baffle configured to separate the interior space of the cabinet into a first portion and a second portion. The module(s) can extend into both the first and second portions of the interior space of the cabinet. The baffle can direct air flowing into the first portion of the interior space of the cabinet through the module(s) and to the second portion of the interior space of the cabinet.

## Description

### CROSS-REFERENCE TO RELATED APPLICATION(S)

This application claims the benefit of U.S. Patent Application No. 63/502,583 filed May 16, 2023.

### TECHNICAL FIELD

The present disclosure relates generally to enclosures with heat generating equipment mounted therein and more specifically relates to cooling a computer equipment cabinet.

### BACKGROUND

As data center owners are trying to increase the efficiency of data centers, the operating ambient conditions of air-cooled servers/IT equipment are trending towards higher operating temperatures. The conventional front door inlet with a rear door exhaust Cold/Hot aisle cooling approach becomes an issue as heightened ambient temperatures can make the space suboptimal for human operation within the Cold and Hot Aisles. To mitigate this issue supply and exhaust air can be contained within the server row, such as with "in-row" cooling units. However, in some applications, mixing of mechanical equipment and IT equipment within the same row/space is not acceptable. Further, conventional dislocated cooling units with dedicated ducting at the bottom and top of the rack are typically limited to low power density to avoid a significant rise in air velocity, which can decrease cooling efficiency and introduce additional problems such as high noise.

### SUMMARY

Applicant has created new and useful devices, systems and methods for cooling a computer equipment cabinet. In at least one example, a system can include a computer cabinet having an interior space, two or more vertical rails coupled within the interior space of the cabinet, one or more rack-mounted computer equipment modules attached between the vertical rails, a first baffle configured to separate the interior space of the cabinet into a first portion and a second portion, or any combination thereof. In at least one example, the module(s) can extend into both the first and second portions of the interior space of the cabinet. In at least one example, the first baffle can direct air flowing into the first portion of the interior space of the cabinet through the module and into the second portion of the interior space of the cabinet. In at least one example, a system can include a second baffle coupling the first baffle with the vertical rails.

In at least one example, a system can include a plurality of modules. In at least one example, each module can extend into both the first and second portions of the interior space of the cabinet. In at least one example, the first baffle can direct air flowing into the first portion of the interior space of the cabinet through the modules and into the second portion of the interior space of the cabinet.

In at least one example, a system can include a first vertical rail disposed adjacent to a right front of the interior space of the cabinet, a second vertical rail disposed adjacent to a right rear of the interior space of the cabinet, a third vertical rail disposed adjacent to a left front of the interior space of the cabinet, a fourth vertical rail disposed adjacent to a left rear of the interior space of the cabinet, or any combination thereof. In at least one example, a system can include a second baffle coupling the first baffle with the first and/or second vertical rails. In at least one example, a system can include a third baffle coupling the first baffle with the third and/or fourth vertical rails.

In at least one example, the first baffle can be vertically disposed within the interior space of the cabinet. In at least one example, a system can include a cold air inlet vent through a bottom surface of the cabinet in communication with the first portion of the interior space of the cabinet. In at least one example, a system can include a hot air outlet vent through a top surface of the cabinet in communication with the second portion of the interior space of the cabinet.

In at least one example, the first baffle can extend from a lower rear of the interior space of the cabinet to an upper front of the interior space of the cabinet, such that the first portion of the interior space of the cabinet includes a front portion of the cabinet and the second portion of the interior space of the cabinet includes a rear portion of the cabinet. In at least one example, a system can include a cold air inlet vent through a bottom surface of the cabinet in communication with the front portion of the cabinet. In at least one example, a system can include a hot air outlet vent through a top surface of the cabinet in communication with the rear portion of the cabinet.

In at least one example, the first baffle can extend from a lower rear of the interior space of the cabinet to an upper front of the interior space of the cabinet, such that a first portion of the interior space of the cabinet includes a front portion of the cabinet and a second portion of the interior space of the cabinet includes a rear portion of the cabinet. In such an example, which is but one of many, the cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through a bottom surface of the cabinet in communication with the front portion of the cabinet and a hot air outlet vent through a top bottom surface of the cabinet in communication with the rear portion of the cabinet. As another example, in at least one example, the system can include a cold air inlet vent through a top surface of the cabinet in communication with the rear portion of the cabinet and a hot air outlet vent through a bottom surface of the cabinet in communication with the front portion of the cabinet.

In at least one example, the first baffle can extend from an upper rear of the interior space of the cabinet to a lower front of the interior space of the cabinet, such that a first (or other) portion of the interior space of the cabinet includes a rear portion of the cabinet and a second (or other) portion of the interior space of the cabinet includes a front portion of the cabinet. In such an example, which is but one of many, the cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through a bottom surface of the cabinet in communication with the rear portion of the cabinet and a hot air outlet vent through a top bottom surface of the cabinet in communication with the front portion of the cabinet. As another example, in at least one example, the system can include a cold air inlet vent through a top surface of the cabinet in communication with the front portion of the cabinet and a hot air outlet vent through a bottom surface of the cabinet in communication with the rear portion of the cabinet.

In at least one example, a cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through one of a top surface of the cabinet and a bottom surface of the cabinet and a hot air outlet vent through the other of the top surface of the cabinet and the bottom surface of the cabinet. In at least one example, a cold air inlet vent can be through the top surface of the cabinet and in communication with one of a front portion of the cabinet and a rear portion of the cabinet. In at least one example, a hot air outlet vent can be through the top surface of the cabinet and in communication with one of a front portion of the cabinet and a rear portion of the cabinet.

In at least one example, the first baffle can provide a first air dam between the at least one rack-mounted computer equipment module and a top interior surface of the cabinet and/or a second air dam between the at least one rack-mounted computer equipment module and a bottom interior surface of the cabinet. In at least one example, the first baffle can provide a third air dam between the at least one rack-mounted computer equipment module and a first side interior surface of the cabinet and/or a fourth air dam between the at least one rack-mounted computer equipment module and a second side interior surface of the cabinet. In at least one example, any one or more of the first, second, third, and fourth air dams can be, or can be part of, a unitary structure.

In at least one example, the system for cooling a computer cabinet having at least two vertical rails configured to support a plurality of rack-mounted computer equipment modules attached thereto can include a first baffle configured to separate an interior space of the cabinet into a first portion and a second portion. In at least one example, the first baffle can direct air flowing into the first portion of the interior space of the cabinet through the modules to the second portion of the interior space of the cabinet. In at least one example, the system for cooling a computer cabinet can include a second baffle coupling the first baffle with the vertical rails.

In at least one example, the system for cooling a computer cabinet can include a first vertical rail disposed adjacent to a right front of the interior space of the cabinet, a second vertical rail disposed adjacent to a right rear of the interior space of the cabinet, a third vertical rail disposed adjacent to a left front of the interior space of the cabinet, a fourth vertical rail disposed adjacent to a left rear of the interior space of the cabinet, or any combination thereof. In at least one example, the system for cooling a computer cabinet can include a second baffle coupling the first baffle with the first and/or second vertical rails. In at least one example, the system for cooling a computer cabinet can include a third baffle coupling the first baffle with the third and/or fourth vertical rails.

In at least one example, the first baffle can extend from a lower rear of the interior space of the cabinet to an upper front of the interior space of the cabinet, such that the first portion of the interior space of the cabinet includes a front portion of the cabinet and the second portion of the interior space of the cabinet includes a rear portion of the cabinet. In at least one example, the system for cooling a computer cabinet can include a cold air inlet vent through a bottom surface of the cabinet in communication with the front portion of the cabinet and/or a hot air outlet vent through a top surface of the cabinet in communication with the rear portion of the cabinet.

In at least one example, the first baffle can provide a first air dam between the at least one rack-mounted computer equipment module and a top interior surface of the cabinet, a second air dam between the at least one rack-mounted computer equipment module and a bottom interior surface of the cabinet, a third air dam between the at least one rack-mounted computer equipment module and a first side interior surface of the cabinet, a fourth air dam between the at least one rack-mounted computer equipment module and a second side interior surface of the cabinet, or any combination thereof. In at least one example, any one or more of the first, second, third, and fourth air dams can be, or can be part of, a unitary structure.

### BRIEF DESCRIPTION OF DRAWINGS

FIG. 1 is a top sectional view of one of many examples of a system for cooling a computer cabinet according to the disclosure.
FIG. 2 is a top sectional view of another one of many examples of a system for cooling a computer cabinet according to the disclosure.
FIG. 3 is a perspective view of one of many examples of a system for cooling a computer cabinet according to the disclosure showing air flow into and out of the cabinet.
FIG. 4 is a partial perspective view of one of many examples of a system for cooling a computer cabinet according to the disclosure showing air flow into and out of the cabinet.
FIG. 5 is a side elevation sectional view of one of many examples of a system for cooling a computer cabinet according to the disclosure showing air velocity through the cabinet.
FIG. 6 is a side elevation sectional view of another one of many examples of a system for cooling a computer cabinet according to the disclosure.
FIG. 7 is a top sectional view of one of many examples of a system for cooling a computer cabinet according to the disclosure.
FIG. 8 is a top sectional view of another one of many examples of a system for cooling a computer cabinet according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can include one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for cooling a computer equipment cabinet. In at least one example, a system according to the disclosure can include one or more computer cabinets having an interior space, two or more rails coupled within the interior space, one or more equipment modules coupled to the rails, and one or more baffles for separating an interior space of the cabinet into two or more portions. In at least one example, one or more modules can be disposed at least partially within each of two or more portions of the interior space of the cabinet. In at least one example, a baffle can direct air flowing into one portion of an interior space of a cabinet through, past or along one or more modules and into another portion of the interior space of the cabinet. In at least one example, a system according to the disclosure can include one or more baffles for coupling one or more other baffles with or to one or more rails. One or more examples of the disclosure are described in more detail below, with reference to the figures.

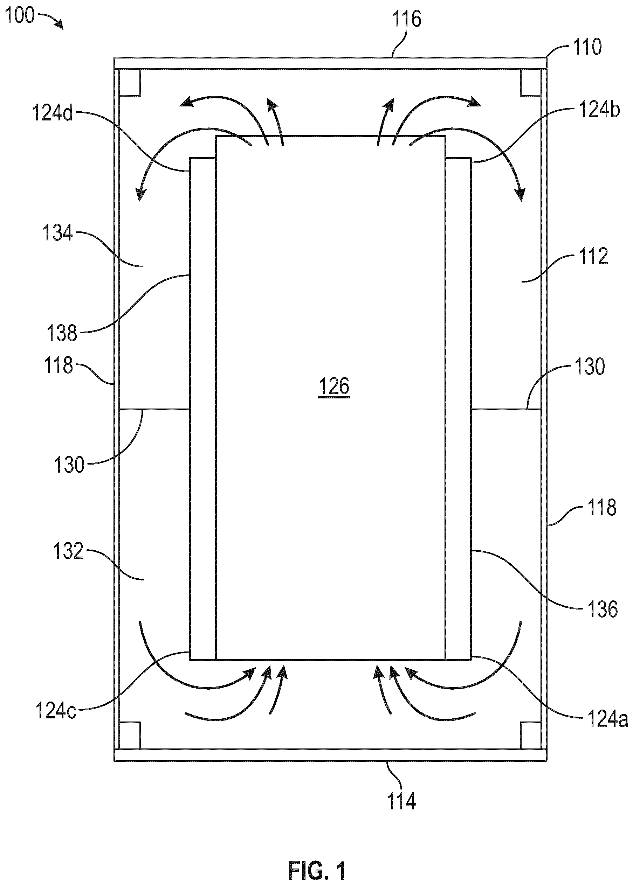

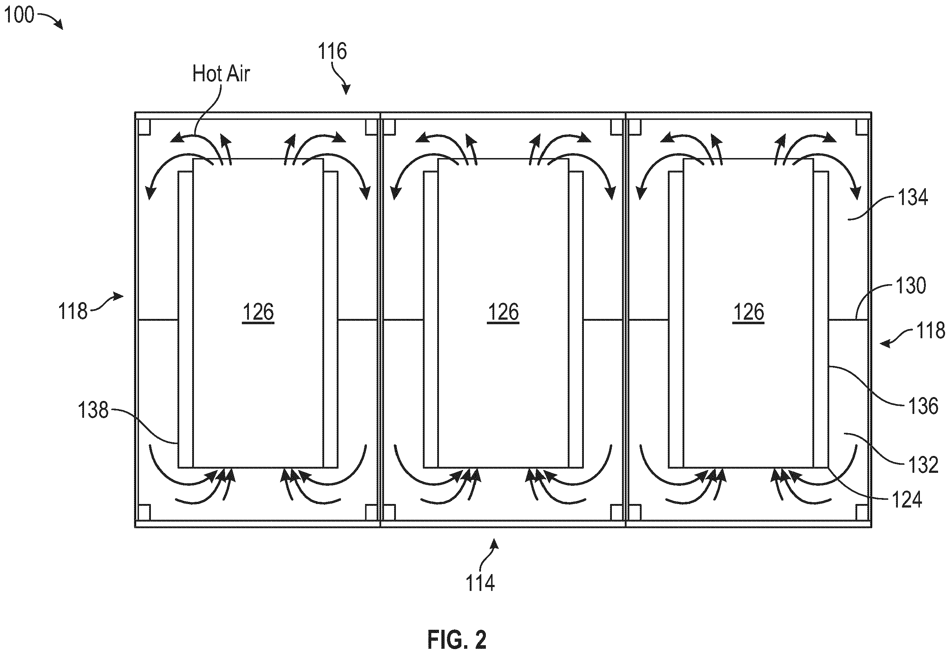

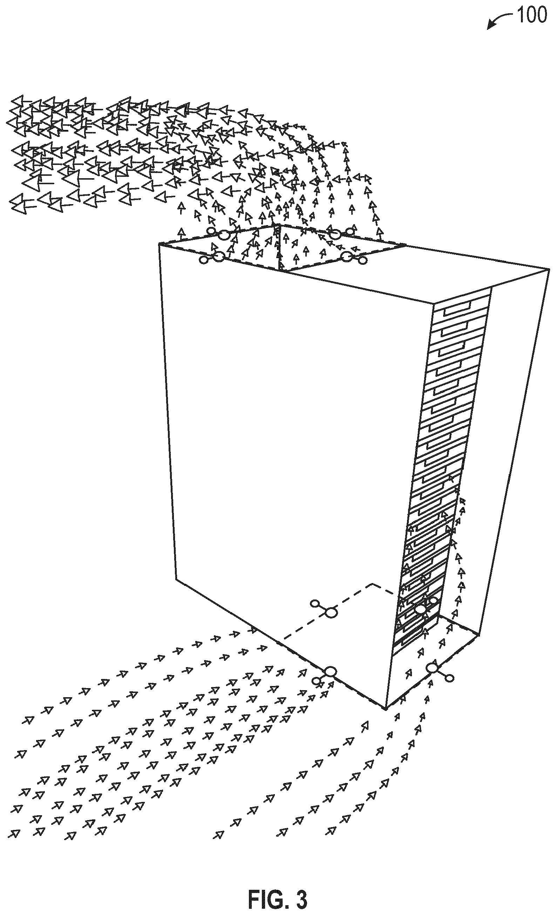

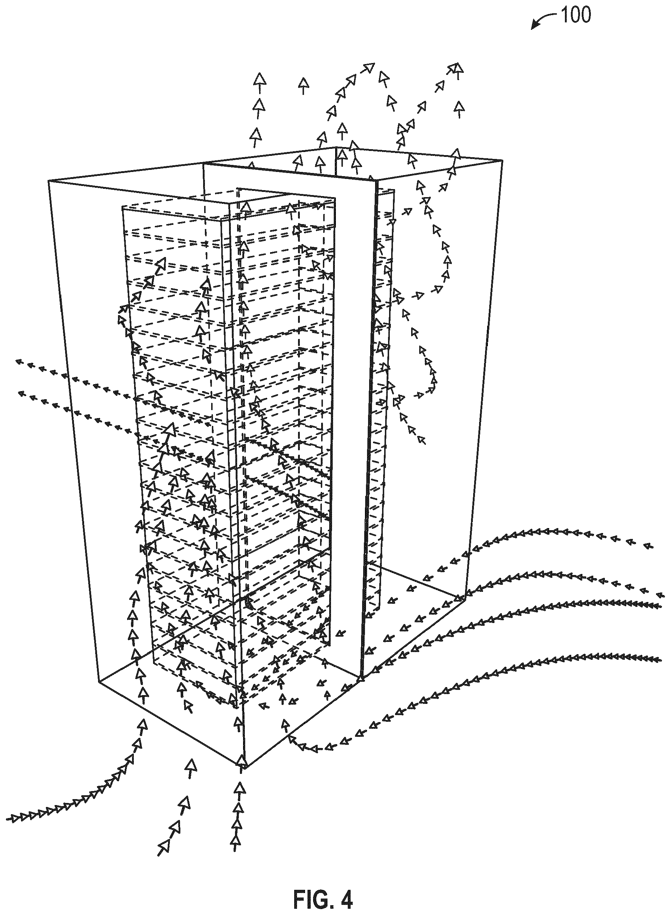

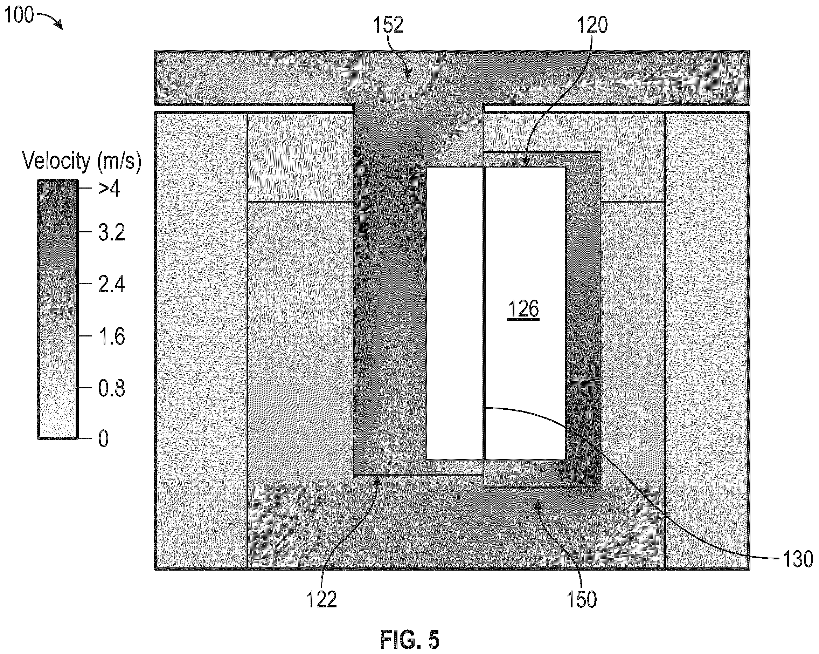

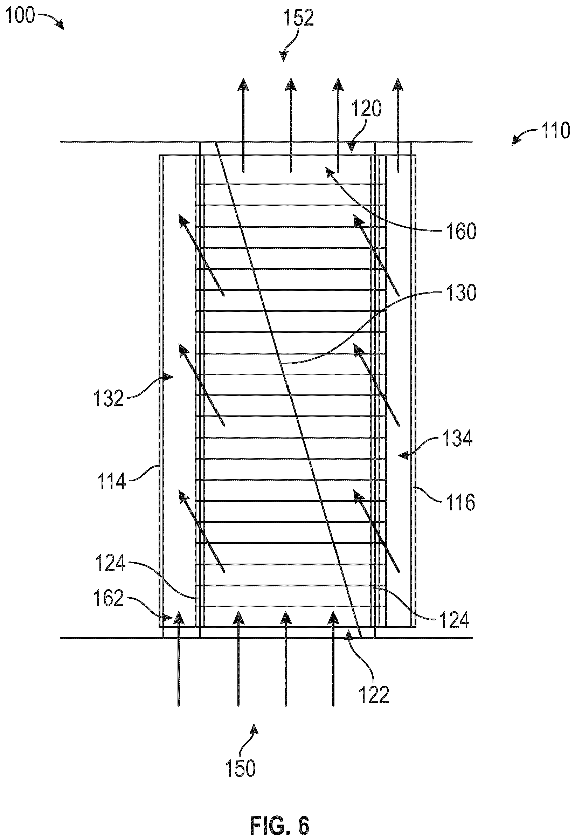

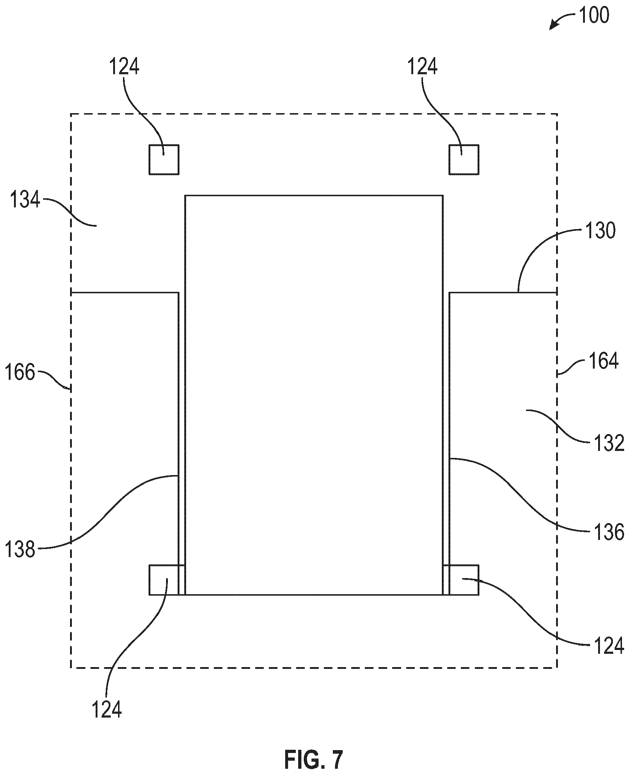

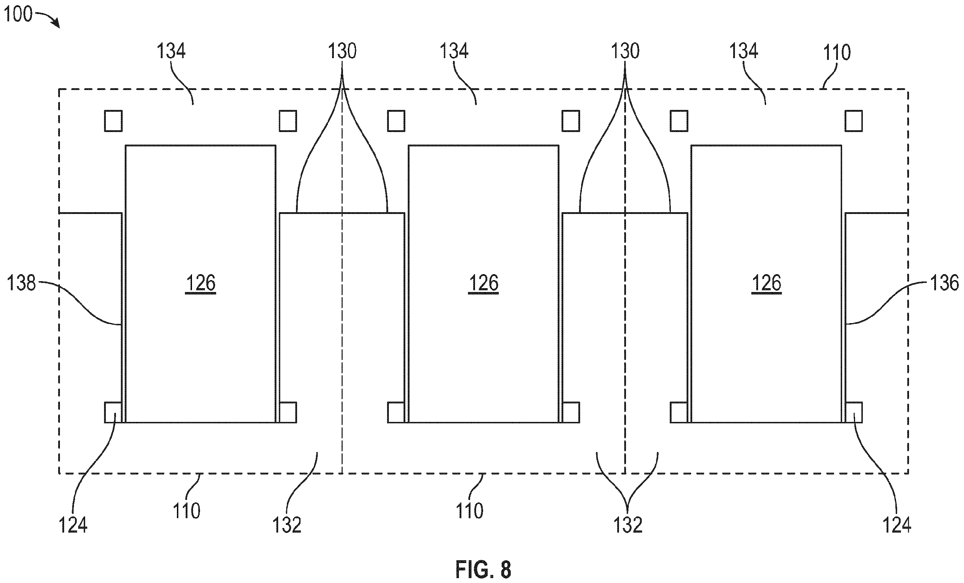

FIG. 1 is a top sectional view of one of many examples of a system for cooling a computer cabinet according to the disclosure. FIG. 2 is a top sectional view of another one of many examples of a system for cooling a computer cabinet according to the disclosure. FIG. 3 is a perspective view of one of many examples of a system for cooling a computer cabinet according to the disclosure showing air flow into and out of the cabinet. FIG. 4 is a partial perspective view of one of many examples of a system for cooling a computer cabinet according to the disclosure showing air flow into and out of the cabinet. FIG. 5 is a side elevation sectional view of one of many examples of a system for cooling a computer cabinet according to the disclosure showing air velocity through the cabinet. FIG. 6 is a side elevation sectional view of another one of many examples of a system for cooling a computer cabinet according to the disclosure. FIG. 7 is a top sectional view of one of many examples of a system for cooling a computer cabinet according to the disclosure. FIG. 8 is a top sectional view of another one of many examples of a system for cooling a computer cabinet according to the disclosure. FIGS. 1-8 are described in conjunction with one another.

In at least one example, the system 100 according to the disclosure, such as a system for cooling or a system for cabinet cooling, can include a computer cabinet 110 having an interior space 112. For example, the computer cabinet 110 can have a front wall or door 114, an opposing rear wall or door 116, one or more side walls 118, a top surface 120, a bottom surface 122, or any combination thereof. In at least one example, two or more computer cabinets 110 can be combined. Combined computer cabinets 110 can include one or more sidewalls 118 between them. In at least one example, combined computer cabinets 110 can omit sidewalls 118 between them, and can have sidewalls 118 on distal ends of the combined cabinets 110, such that the combined cabinets 110 share a common interior space 112.

In at least one example, the computer cabinet 110 can have two or more rails, such as vertical (i.e., at least about vertical) rails 124, disposed within the interior space 112, and one or more rack-mounted computer equipment modules 126 coupled to the vertical rails 124. The modules 126 can produce heat within the cabinet 110. An external cooling system (not shown) can provide cool air, or another cooling media, to the cabinet 110 and/or can remove hot air, or another cooling media, from the cabinet 110.

In at least one example, the computer cabinet 110 can have one or more baffles 130 for separating the interior space 112 of the cabinet 110 into a first portion 132, such as a front portion, and a second portion 134, such as a rear portion. In at least one example, the module(s) 126 can extend into both the first and second portions 132, 134 of the interior space 112 of the cabinet 110. In at least one example, the baffles 130 can force cool air entering the cabinet 110 to flow through the module(s) 126 before exiting the cabinet 110. For example, the baffles 130 can direct air flowing into the first portion 132 of the interior space 112 of the cabinet 110 through the module(s) 126 into the second portion 134 of the interior space 112 of the cabinet 110. In at least one example, the system 100 can include a second baffle 136 and/or third baffle 138 coupling the first baffle 130 with one or more of the vertical rails 124.

In at least one example, the system 100 can include a plurality of modules 126. In at least one example, each module 126 can extend into both the first and second portions 132, 134 of the interior space 112 of the cabinet 110. In at least one example, the baffle 130 can direct air flowing into the first portion 132 of the interior space 112 of the cabinet 110 through any or all of the modules 126 and into the second portion 134 of the interior space 112 of the cabinet 110. For example, the baffle 130 can direct air flowing into the first portion 132 of the interior space 112 through select ones of the modules 126 and into the second portion 134 of the interior space 112. For example, the baffle 130 can direct air flowing into the first portion 132 of the interior space 112 through each module 126 and into the second portion 134 of the interior space 112. In at least one example, the baffle 130 can direct air flowing into the first portion 132 of the interior space 112 through all of the modules 126 and into the second portion 134 of the interior space 112.

In at least one example, the system 100 can include a first vertical rail 124a coupled adjacent to a right front of the interior space 112 of the cabinet 110, a second vertical rail 124b coupled adjacent to a right rear of the interior space 112 of the cabinet 110, a third vertical rail 124c coupled adjacent to a left front of the interior space 112 of the cabinet 100, a fourth vertical rail 124d coupled adjacent to a left rear of the interior space 112 of the cabinet 100, or any combination thereof. In at least one example, the system 100 can include another baffle 136 coupling the first baffle 130 with the first and/or second vertical rails 124a, 124b. In at least one example, the system 100 can include a third baffle 138 coupling the first baffle 130 with the third and/or fourth vertical rails 124c, 124d.

Any or all of the baffles 130, 136, 138 can be integral or distinct and joined together during installation. Any of the baffles 130, 136, 138 can be constructed of multiple components, which can be joined together during installation. In at least one example, all of the baffles 130, 136, 138 can be integrally formed as one unit. In at least one example, each of the baffles 130, 136, 138 can be integrally formed and joined together during installation. In at least one example, the first baffle 130 can be integrally formed as one unit and the second and third baffles 136, 138 can be integrally formed as another unit, with the two units joined together during installation. In at least one example, the first baffle 130 from each cabinet 110 can be integrally formed as one unit. In at least one example, the first baffle 130 from each cabinet 110 can be separately formed and joined together during installation.

In at least one example, the first baffle 130 can be vertically oriented within the interior space 112 of the cabinet 110. In at least one example, the system 100 can include a cold air inlet vent 150 through a bottom surface 122 of the cabinet 110 in communication with the first portion 132 of the interior space 112 of the cabinet 110. In at least one example, the cold air inlet vent 150 can occupy about half or a minority portion of the bottom surface 122 of the cabinet 110. In at least one example, the system 100 can include a hot air outlet vent 152 through a top surface 120 of the cabinet 110 in communication with the second portion 134 of the interior space 112 of the cabinet 110. In at least one example, the hot air outlet vent 152 can occupy about half or a minority portion of the top surface 120 of the cabinet 110.

In at least one example, the first baffle 130 can extend from a lower rear of the interior space 112 of the cabinet 110 to an upper front of the interior space 112 of the cabinet 110, such that the first portion 132 of the interior space 112 of the cabinet 110 includes a front portion of the cabinet 110 and the second portion 134 of the interior space 112 of the cabinet 110 includes a rear portion of the cabinet 110. As another example, in at least one example, the first baffle 130 can extend from an upper rear of the interior space 112 of the cabinet 110 to a lower front of the interior space 112 of the cabinet 110, such that the first portion 132 of the interior space 112 of the cabinet 110 includes a rear portion of the cabinet 110 and the second portion 134 of the interior space 112 of the cabinet 110 includes a front portion of the cabinet 110. In at least one example, the system 100 can include a cold air inlet vent 150 through a bottom surface 122 of the cabinet 110 in communication with the front portion 132 of the cabinet 110. In at least one example, the cold air inlet vent 150 can occupy all or a majority of the bottom surface 122 of the cabinet 110. In at least one example, the system 100 can include a hot air outlet vent 152 through a top surface 120 of the cabinet 110 in communication with the rear portion 134 of the cabinet 110.

In at least one example, the hot air outlet vent 152 can occupy all or a majority of the top surface 120 of the cabinet 110. In at least one example, the system 100 can include a cold air inlet vent 150 through a top surface 120 of the cabinet 110 in communication with the first portion 132 of the cabinet 110 and/or a hot air outlet vent 152 through a bottom surface 122 of the cabinet 110 in communication with the second portion 134 of the cabinet 110. In at least one example, the system 100 can include a cold air inlet vent 150 through a first side surface of the cabinet 110 in communication with the first portion 132 of the cabinet 110 and/or a hot air outlet vent 152 through an opposing side surface of the cabinet 110 in communication with the second portion 134 of the cabinet 110. In at least one example, the system 100 can include a cold air inlet vent 150 through a front surface of the cabinet 110 in communication with the first portion 132 of the cabinet 110 and/or a hot air outlet vent 152 through a rear of the cabinet 110 in communication with the second portion 134 of the cabinet 110.

In at least one example, the first baffle 130 can provide a first air dam between the at least one rack-mounted computer equipment module 126 and a top interior surface 160 of the cabinet 110 and/or a second air dam between the at least one rack-mounted computer equipment module 126 and a bottom interior surface 162 of the cabinet 110. In at least one example, the first baffle 130 can provide a third air dam between the at least one rack-mounted computer equipment module 126 and a first side interior surface 164 of the cabinet 110 and/or a fourth air dam between the at least one rack-mounted computer equipment module 126 and a second side interior surface 166 of the cabinet 110. In at least one example, any one or more of the first, second, third, and fourth air dams can be part of a unitary structure.

In at least one example, the system 100 for cooling a computer cabinet 110 having at least two vertical rails 124 configured to support a plurality of rack-mounted computer equipment modules 126 attached thereto can include a first baffle 130 configured to separate an interior space 112 of the cabinet 110 into a first portion 132 and a second portion 134. In at least one example, the first baffle 130 can direct air flowing into the first portion 132 of the interior space 112 of the cabinet 110 through the modules 126 to the second portion 134 of the interior space 112 of the cabinet 110. In at least one example, the system 100 for cooling a computer cabinet 110 can include a second and/or third baffle 136, 138 coupling the first baffle 130 with or to the vertical rails 124.

In at least one example, the system 100 for cooling a computer cabinet 110 can include a first vertical rail 124a disposed adjacent to a right front of the interior space 112 of the cabinet 110, a second vertical rail 124b disposed adjacent to a right rear of the interior space 112 of the cabinet 110, a third vertical rail 124c disposed adjacent to a left front of the interior space 112 of the cabinet 110, a fourth vertical rail 124d disposed adjacent to a left rear of the interior space 112 of the cabinet 110, or any combination thereof. In at least one example, the system 100 for cooling a computer cabinet 110 can include a second baffle 136 coupling the first baffle 130 with the first and/or second vertical rails 124a, 124b. In at least one example, the system 100 for cooling a computer cabinet 110 can include a third baffle 138 coupling the first baffle 130 with the third and/or fourth vertical rails 124c, 124d.

In at least one example, the first baffle 130 can extend from a lower rear of the interior space 112 of the cabinet 110 to an upper front of the interior space 112 of the cabinet 110, such that the first portion 132 of the interior space 112 of the cabinet 110 includes a front portion of the cabinet 110 and the second portion 134 of the interior space 112 of the cabinet 110 includes a rear portion of the cabinet. As another example, in at least one example, the first baffle 130 can extend from an upper rear of the interior space 112 of the cabinet 110 to a lower front of the interior space 112 of the cabinet 110, such that the first portion 132 of the interior space 112 of the cabinet 110 includes a rear portion of the cabinet 110 and the second portion 134 of the interior space 112 of the cabinet 110 includes a front portion of the cabinet 110. In at least one example, the system 100 for cooling a computer cabinet 110 can include a cold air inlet vent 150 through a bottom surface 122 of the cabinet 110 in communication with the front portion 132 of the cabinet 110 and/or a hot air outlet vent 152 through a top surface 120 of the cabinet 110 in communication with the rear portion 134 of the cabinet 110. In at least one example, the system 100 for cooling a computer cabinet 110 can include a cold air inlet vent 150 through a top surface 120 of the cabinet 110 in communication with the first portion 132 of the cabinet 110 and/or a hot air outlet vent 152 through a bottom surface 122 of the cabinet 110 in communication with the second portion 134 of the cabinet 110.

In at least one example, the system 100 can include a cold air inlet vent 150 through a first side surface of the cabinet 110 in communication with the first portion 132 of the cabinet 110 and/or a hot air outlet vent 152 through an opposing side surface of the cabinet 110 in communication with the second portion 134 of the cabinet 110. In at least one example, the system 100 can include a cold air inlet vent 150 through a front surface of the cabinet 110 in communication with the first portion 132 of the cabinet 110 and/or a hot air outlet vent 152 through a rear of the cabinet 110 in communication with the second portion 134 of the cabinet 110.

In at least one example, the first baffle 130 can provide a first air dam between the at least one rack-mounted computer equipment module 126 and a top interior surface 160 of the cabinet 110, a second air dam between the at least one rack-mounted computer equipment module 126 and a bottom interior surface 164 of the cabinet 110, a third air dam between the at least one rack-mounted computer equipment module 126 and a first side interior surface 164 of the cabinet 110, a fourth air dam between the at least one rack-mounted computer equipment module 126 and a second side interior surface 166 of the cabinet 110, or any combination thereof. In at least one example, any one or more of the first, second, third, and fourth air dams can be part of a unitary, or integrally formed, structure.

In at least one example, the system for cooling a computer cabinet can include a computer cabinet having an interior space, two or more vertical rails disposed within the interior space of the cabinet, one or more rack-mounted computer equipment modules attached between the vertical rails, a first baffle configured to separate the interior space of the cabinet into a first portion and a second portion, or any combination thereof. In at least one example, the module(s) can extend into both the first and second portions of the interior space of the cabinet. In at least one example, the first baffle can direct air flowing into the first portion of the interior space of the cabinet through the module into the second portion of the interior space of the cabinet. In at least one example, a system can include a second baffle coupling the first baffle with the vertical rails.

In at least one example, a system can include a plurality of modules. In at least one example, each module can extend into both the first and second portions of the interior space of the cabinet. In at least one example, the first baffle can direct air flowing into the first portion of the interior space of the cabinet through the modules and into the second portion of the interior space of the cabinet.

In at least one example, a system can include a first vertical rail disposed adjacent to a right front of the interior space of the cabinet, a second vertical rail disposed adjacent to a right rear of the interior space of the cabinet, a third vertical rail disposed adjacent to a left front of the interior space of the cabinet, a fourth vertical rail disposed adjacent to a left rear of the interior space of the cabinet, or any combination thereof. In at least one example, a system can include a second baffle coupling the first baffle with the first and/or second vertical rails. In at least one example, a system can include a third baffle coupling the first baffle with the third and/or fourth vertical rails.

In at least one example, the first baffle can be vertically disposed within the interior space of the cabinet. In at least one example, a system can include a cold air inlet vent through a bottom surface of the cabinet in communication with the first portion of the interior space of the cabinet. In at least one example, a system can include a hot air outlet vent through a top surface of the cabinet in communication with the second portion of the interior space of the cabinet.

In at least one example, the first baffle can extend from a lower rear of the interior space of the cabinet to an upper front of the interior space of the cabinet, such that the first portion of the interior space of the cabinet includes a front portion of the cabinet and the second portion of the interior space of the cabinet includes a rear portion of the cabinet. In at least one example, a system can include a cold air inlet vent through a bottom surface of the cabinet in communication with the front portion of the cabinet. In at least one example, a system can include a hot air outlet vent through a top surface of the cabinet in communication with the rear portion of the cabinet.

In at least one example, the first baffle can extend from a lower rear of the interior space of the cabinet to an upper front of the interior space of the cabinet, such that a first portion of the interior space of the cabinet includes a front portion of the cabinet and a second portion of the interior space of the cabinet includes a rear portion of the cabinet. In such an example, which is but one of many, the cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through a bottom surface of the cabinet in communication with the front portion of the cabinet and a hot air outlet vent through a top bottom surface of the cabinet in communication with the rear portion of the cabinet. As another example, in at least one example, the system can include a cold air inlet vent through a top surface of the cabinet in communication with the rear portion of the cabinet and a hot air outlet vent through a bottom surface of the cabinet in communication with the front portion of the cabinet.

In at least one example, the first baffle can extend from an upper rear of the interior space of the cabinet to a lower front of the interior space of the cabinet, such that a first (or other) portion of the interior space of the cabinet includes a rear portion of the cabinet and a second (or other) portion of the interior space of the cabinet includes a front portion of the cabinet. In such an example, which is but one of many, the cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through a bottom surface of the cabinet in communication with the rear portion of the cabinet and a hot air outlet vent through a top bottom surface of the cabinet in communication with the front portion of the cabinet. As another example, in at least one example, the system can include a cold air inlet vent through a top surface of the cabinet in communication with the front portion of the cabinet and a hot air outlet vent through a bottom surface of the cabinet in communication with the rear portion of the cabinet.

In at least one example, a cabinet can include one or more vents or other openings, such as a cold air inlet vent for routing or otherwise allowing relatively cool air into the cabinet and a hot air outlet vent for routing or otherwise allowing relatively warm air out of the cabinet. For example, in at least one example, the system can include a cold air inlet vent through one of a top surface of the cabinet and a bottom surface of the cabinet and a hot air outlet vent through the other of the top surface of the cabinet and the bottom surface of the cabinet. In at least one example, a cold air inlet vent can be through the top surface of the cabinet and in communication with one of a front portion of the cabinet and a rear portion of the cabinet. In at least one example, a hot air outlet vent can be through the top surface of the cabinet and in communication with one of a front portion of the cabinet and a rear portion of the cabinet.

In at least one example, the first baffle can provide a first air dam between the at least one rack-mounted computer equipment module and a top interior surface of the cabinet and/or a second air dam between the at least one rack-mounted computer equipment module and a bottom interior surface of the cabinet. In at least one example, the first baffle can provide a third air dam between the at least one rack-mounted computer equipment module and a first side interior surface of the cabinet and/or a fourth air dam between the at least one rack-mounted computer equipment module and a second side interior surface of the cabinet. In at least one example, any one or more of the first, second, third, and fourth air dams can be, or can be part of, a unitary structure.

In at least one example, the system for cooling a computer cabinet having at least two vertical rails configured to support a plurality of rack-mounted computer equipment modules attached thereto can include a first baffle configured to separate an interior space of the cabinet into a first portion and a second portion. In at least one example, the first baffle can direct air flowing into the first portion of the interior space of the cabinet through the modules to the second portion of the interior space of the cabinet. In at least one example, the system for cooling a computer cabinet can include a second baffle coupling the first baffle with the vertical rails.

In at least one example, the system for cooling a computer cabinet can include a first vertical rail disposed adjacent to a right front of the interior space of the cabinet, a second vertical rail disposed adjacent to a right rear of the interior space of the cabinet, a third vertical rail disposed adjacent to a left front of the interior space of the cabinet, a fourth vertical rail disposed adjacent to a left rear of the interior space of the cabinet, or any combination thereof. In at least one example, the system for cooling a computer cabinet can include a second baffle coupling the first baffle with the first and/or second vertical rails. In at least one example, the system for cooling a computer cabinet can include a third baffle coupling the first baffle with the third and/or fourth vertical rails.

In at least one example, the first baffle can extend from a lower rear of the interior space of the cabinet to an upper front of the interior space of the cabinet, such that the first portion of the interior space of the cabinet includes a front portion of the cabinet and the second portion of the interior space of the cabinet includes a rear portion of the cabinet. In at least one example, the system for cooling a computer cabinet can include a cold air inlet vent through a bottom surface of the cabinet in communication with the front portion of the cabinet and/or a hot air outlet vent through a top surface of the cabinet in communication with the rear portion of the cabinet. In at least one example, the system can include a cold air inlet vent through the top surface of the cabinet and in communication with one of the front portion of the cabinet and the rear portion of the cabinet. In at least one example, the system can include a hot air outlet vent through the top surface of the cabinet and in communication with one of the front portion of the cabinet and the rear portion of the cabinet.

In at least one example, the first baffle can provide a first air dam between the at least one rack-mounted computer equipment module and a top interior surface of the cabinet, a second air dam between the at least one rack-mounted computer equipment module and a bottom interior surface of the cabinet, a third air dam between the at least one rack-mounted computer equipment module and a first side interior surface of the cabinet, a fourth air dam between the at least one rack-mounted computer equipment module and a second side interior surface of the cabinet, or any combination thereof. In at least one example, any one or more of the first, second, third, and fourth air dams can be, or can be part of, a unitary structure.

Other and further examples utilizing one or more aspects of the disclosure can be devised without departing from the scope of Applicant' disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A cooling system, comprising:
   a computer cabinet having an interior space;
   at least two vertical rails mounted within the interior space of the cabinet;
   at least one rack mounted computer equipment module attached between the vertical rails within the interior space of the cabinet; and
   a first baffle configured to separate the interior space of the cabinet into a first portion and a second portion, wherein the at least one rack mounted computer equipment module extends into both the first and second portions of the interior space of the cabinet, and wherein the first baffle directs air flowing into the first portion of the interior space of the cabinet through the module and to the second portion of the interior space of the cabinet.
2. The system of clause 1, wherein the at least one rack mounted computer equipment module comprises a plurality of modules, with each module extending into both the first and second portions of the interior space of the cabinet; and wherein the first baffle directs air flowing into the first portion of the interior space of the cabinet through the plurality of modules and to the second portion of the interior space of the cabinet.
3. The system of clause 1, further comprising a second baffle coupling the first baffle with the vertical rails.
4. The system of clause 1, wherein the at least two vertical rails comprise a first vertical rail mounted adjacent to a right front of the interior space of the cabinet, a second vertical rail mounted adjacent to a right rear of the interior space of the cabinet, a third vertical rail mounted adjacent to a left front of the interior space of the cabinet, and a fourth vertical rail mounted adjacent to a left rear of the interior space of the cabinet; and further comprising a second baffle that couples the first baffle with the first and second vertical rails and a third baffle that couples the first baffle with the third and fourth vertical rails.
5. The system of clause 1, wherein the first baffle is vertically mounted within the interior space of the cabinet.
6. The system of clause 5, further comprising a cold air inlet vent through a bottom surface of the cabinet in communication with the first portion of the interior space of the cabinet.
7. The system of clause 5, further comprising a hot air outlet vent through a top surface of the cabinet in communication with the second portion of the interior space of the cabinet.
8. The system of clause 1, wherein the first baffle extends from one of (a) a lower rear of the interior space of the cabinet to an upper front of the interior space of the cabinet, such that the first portion of the interior space of the cabinet comprises a front portion of the cabinet and the second portion of the interior space of the cabinet comprises a rear portion of the cabinet, and (b) an upper rear of the interior space of the cabinet to a lower front of the interior space of the cabinet, such that the first portion of the interior space of the cabinet comprises a rear portion of the cabinet and the second portion of the interior space of the cabinet comprises a front portion of the cabinet.
9. The system of clause 8, further comprising a cold air inlet vent through a bottom surface of the cabinet and a hot air outlet vent through a top surface of the cabinet.
10. The system of clause 8, further comprising a hot air outlet vent through a bottom surface of the cabinet and a cold air inlet vent through a top surface of the cabinet.
11. The system of clause 1, wherein the first baffle provides a first air dam between the at least one rack mounted computer equipment module and a top interior surface of the cabinet and a second air dam between the at least one rack mounted computer equipment module and a bottom interior surface of the cabinet.
12. The system of clause 11, wherein the first baffle provides a third air dam between the at least one rack mounted computer equipment module and a first side interior surface of the cabinet and a fourth air dam between the at least one rack mounted computer equipment module and a second side interior surface of the cabinet.
13. The system of clause 12, wherein the first, second, third, and fourth air dams are a unitary structure.
14. A system for cooling a computer cabinet having at least two vertical rails configured to support a plurality of rack mounted computer equipment modules attached thereto, the system comprising:
   a first baffle configured to separate an interior space of the cabinet into a
   first portion and a second portion, wherein the first baffle directs air flowing into the first portion of the interior space of the cabinet through the modules and to the second portion of the interior space of the cabinet.
15. The system of clause 14, further comprising a second baffle that couples the first baffle with the vertical rails.
16. The system of clause 14, wherein the at least two vertical rails comprise a first vertical rail mounted adjacent to a right front of the interior space of the cabinet, a second vertical rail mounted adjacent to a right rear of the interior space of the cabinet, a third vertical rail mounted adjacent to a left front of the interior space of the cabinet, and a fourth vertical rail mounted adjacent to a left rear of the interior space of the cabinet; and further comprising a second baffle that couples the first baffle with the first and second vertical rails and a third baffle that couples the first baffle with the third and fourth vertical rails.
17. The system of clause 14, wherein the first baffle extends from one of (a) a lower rear of the interior space of the cabinet to an upper front of the interior space of the cabinet, such that the first portion of the interior space of the cabinet comprises a front portion of the cabinet and the second portion of the interior space of the cabinet comprises a rear portion of the cabinet, and (b) an upper rear of the interior space of the cabinet to a lower front of the interior space of the cabinet, such that the first portion of the interior space of the cabinet comprises a rear portion of the cabinet and the second portion of the interior space of the cabinet comprises a front portion of the cabinet.
18. The system of clause 17, further comprising a cold air inlet vent through one of a top surface of the cabinet and a bottom surface of the cabinet and a hot air outlet vent through the other of the top surface of the cabinet and the bottom surface of the cabinet.
19. The system of clause 14, wherein the first baffle provides a first air dam between the at least one rack mounted computer equipment module and a top interior surface of the cabinet, a second air dam between the at least one rack mounted computer equipment module and a bottom interior surface of the cabinet, a third air dam between the at least one rack mounted computer equipment module and a first side interior surface of the cabinet, and a fourth air dam between the at least one rack mounted computer equipment module and a second side interior surface of the cabinet.
20. The system of clause 19, wherein the first, second, third, and fourth air dams are a unitary structure.
21. The system of clause 18, wherein the cold air inlet vent is through the top surface of the cabinet and in communication with one of the front portion of the cabinet and the rear portion of the cabinet.
22. The system of clause 18, wherein the hot air outlet vent is through the top surface of the cabinet and in communication with one of the front portion of the cabinet and the rear portion of the cabinet.
23. A system as shown and/or described herein.
24. A device as shown and/or described herein.
25. A method as shown and/or described herein.

Further examples are set out in the items below:
1.A system for cooling a computer cabinet, comprising:
   a computer cabinet having an interior space;
   at least two vertical rails disposed within the interior space of the cabinet;
   at least one rack-mounted computer equipment module disposed between the vertical rails within the interior space of the cabinet; and
   a first baffle configured to separate the interior space of the cabinet into a first portion and a second portion,
   wherein the at least one rack-mounted computer equipment module extends into both the first and second portions of the interior space of the cabinet, and
   wherein the first baffle directs air flowing into the first portion of the interior space of the cabinet through the at least one rack-mounted computer equipment module and to the second portion of the interior space of the cabinet.
2.The system of item 1, wherein the at least one rack-mounted computer equipment module comprises a plurality of modules, with each module extending into both the first and second portions of the interior space of the cabinet, and
   wherein the first baffle directs air flowing into the first portion of the interior space of the cabinet through the plurality of modules and to the second portion of the interior space of the cabinet.
3.The system of item 1 or 2, further comprising a second baffle coupling the first baffle with the at least two vertical rails.
4.The system of any one of the preceding items, wherein the at least two vertical rails comprise:
   a first vertical rail disposed adjacent to a right front of the interior space of the cabinet;
   a second vertical rail disposed adjacent to a right rear of the interior space of the cabinet;
   a third vertical rail disposed adjacent to a left front of the interior space of the cabinet; and a fourth vertical rail disposed adjacent to a left rear of the interior space of the cabinet; and
   wherein the system further comprises:
      a second baffle that couples the first baffle with the first and second vertical rails; and
      a third baffle that couples the first baffle with the third and fourth vertical rails.
5.The system of any one of the preceding items, wherein the first baffle is vertically disposed within the interior space of the cabinet.
6.The system of item 5, further comprising:
   a cold air inlet vent through a bottom surface of the cabinet in communication with the first portion of the interior space of the cabinet; and
   a hot air outlet vent through a top surface of the cabinet in communication with the second portion of the interior space of the cabinet.
7.The system of any one of the preceding items, wherein the first baffle extends from a lower rear of the interior space of the cabinet to an upper front of the interior space of the cabinet, wherein the first portion of the interior space of the cabinet comprises a front portion of the cabinet, and wherein the second portion of the interior space of the cabinet comprises a rear portion of the cabinet.
8.The system of item 7, further comprising:
   a cold air inlet vent through a bottom surface of the cabinet; and
   a hot air outlet vent through a top surface of the cabinet.
9.The system of item 7, further comprising:
   a hot air outlet vent through a bottom surface of the cabinet; and
   a cold air inlet vent through a top surface of the cabinet.
10.The system of any one of the preceding items, wherein the first baffle extends from an upper rear of the interior space of the cabinet to a lower front of the interior space of the cabinet, wherein the first portion of the interior space of the cabinet comprises a rear portion of the cabinet, and wherein the second portion of the interior space of the cabinet comprises a front portion of the cabinet.
11. The system of any one of the preceding items, wherein the first baffle defines a first air dam between the at least one rack-mounted computer equipment module and a top interior surface of the cabinet, and a second air dam between the at least one rack-mounted computer equipment module and a bottom interior surface of the cabinet.
12.The system of item 11, wherein the first baffle further defines a third air dam between the at least one rack-mounted computer equipment module and a first side interior surface of the cabinet, and a fourth air dam between the at least one rack-mounted computer equipment module and a second side interior surface of the cabinet.
13.The system of item 12, wherein the first, second, third, and fourth air dams are a unitary structure.
14.A system for cooling a computer cabinet having at least two vertical rails configured to support a plurality of rack-mounted computer equipment modules which are attached to the at least two vertical rails, the system comprising:
   a first baffle configured to separate an interior space of the cabinet into a first portion and a second portion, wherein the first baffle directs air flowing into the first portion of the interior space of the cabinet through the modules and to the second portion of the interior space of the cabinet.
15.The system of item 14, further comprising a second baffle that couples the first baffle with the at least two vertical rails.
16.The system of item 14 or 15, wherein the at least two vertical rails comprise:
   a first vertical rail disposed adjacent to a right front of the interior space of the cabinet;
   a second vertical rail disposed adjacent to a right rear of the interior space of the cabinet;
   a third vertical rail disposed adjacent to a left front of the interior space of the cabinet; and
   a fourth vertical rail disposed adjacent to a left rear of the interior space of the cabinet; and
   wherein the system further comprises a second baffle that couples the first baffle with the first and second vertical rails and a third baffle that couples the first baffle with the third and fourth vertical rails.
17.The system of item 14, wherein the first baffle extends from a lower rear of the interior space of the cabinet to an upper front of the interior space of the cabinet, wherein the first portion of the interior space of the cabinet comprises a front portion of the cabinet, and wherein the second portion of the interior space of the cabinet comprises a rear portion of the cabinet.
18.The system of item 17, further comprising:
   a cold air inlet vent through one of a top surface of the cabinet and a bottom surface of the cabinet; and
   a hot air outlet vent through the other of the top surface of the cabinet and the bottom surface of the cabinet.
19.The system of item 14, wherein the first baffle extends from an upper rear of the interior space of the cabinet to a lower front of the interior space of the cabinet, wherein the first portion of the interior space of the cabinet comprises a rear portion of the cabinet, and wherein the second portion of the interior space of the cabinet comprises a front portion of the cabinet.
20. The system of item 14, wherein the first baffle defines a first air dam between the at least one rack-mounted computer equipment module and a top interior surface of the cabinet, a second air dam between the at least one rack-mounted computer equipment module and a bottom interior surface of the cabinet, a third air dam between the at least one rack-mounted computer equipment module and a first side interior surface of the cabinet, and a fourth air dam between the at least one rack-mounted computer equipment module and a second side interior surface of the cabinet.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

## Claims

1. A system for cooling a computer cabinet, comprising:
a computer cabinet having an interior space;
at least two vertical rails disposed within the interior space of the cabinet;
at least one rack-mounted computer equipment module disposed between the vertical rails within the interior space of the cabinet; and
a first baffle configured to separate the interior space of the cabinet into a first portion and a second portion,
wherein the at least one rack-mounted computer equipment module extends into both the first and second portions of the interior space of the cabinet, and
wherein the first baffle directs air flowing into the first portion of the interior space of the cabinet through the at least one rack-mounted computer equipment module and to the second portion of the interior space of the cabinet.

2. The system of claim 1, wherein the at least one rack-mounted computer equipment module comprises a plurality of modules, with each module extending into both the first and second portions of the interior space of the cabinet, and
wherein the first baffle directs air flowing into the first portion of the interior space of the cabinet through the plurality of modules and to the second portion of the interior space of the cabinet; or optionally
further comprising a second baffle coupling the first baffle with the at least two vertical rails; or optionally
wherein the at least two vertical rails comprise:
a first vertical rail disposed adjacent to a right front of the interior space of the cabinet;
a second vertical rail disposed adjacent to a right rear of the interior space of the cabinet;
a third vertical rail disposed adjacent to a left front of the interior space of the cabinet; and
a fourth vertical rail disposed adjacent to a left rear of the interior space of the cabinet; and
wherein the system further comprises:
a second baffle that couples the first baffle with the first and second vertical rails; and
a third baffle that couples the first baffle with the third and fourth vertical rails.

3. The system of claim 1, wherein the first baffle is vertically disposed within the interior space of the cabinet.

4. The system of claim 3, further comprising:
a cold air inlet vent through a bottom surface of the cabinet in communication with the first portion of the interior space of the cabinet; and
a hot air outlet vent through a top surface of the cabinet in communication with the second portion of the interior space of the cabinet.

5. The system of claim 1, wherein the first baffle extends from a lower rear of the interior space of the cabinet to an upper front of the interior space of the cabinet, wherein the first portion of the interior space of the cabinet comprises a front portion of the cabinet, and wherein the second portion of the interior space of the cabinet comprises a rear portion of the cabinet.

6. The system of claim 5, further comprising:
a cold air inlet vent through a bottom surface of the cabinet; and a hot air outlet vent through a top surface of the cabinet; or optionally further comprising:
a hot air outlet vent through a bottom surface of the cabinet; and
a cold air inlet vent through a top surface of the cabinet.

7. The system of claim 1, wherein the first baffle extends from an upper rear of the interior space of the cabinet to a lower front of the interior space of the cabinet, wherein the first portion of the interior space of the cabinet comprises a rear portion of the cabinet, and wherein the second portion of the interior space of the cabinet comprises a front portion of the cabinet.

8. The system of claim 1, wherein the first baffle defines a first air dam between the at least one rack-mounted computer equipment module and a top interior surface of the cabinet, and a second air dam between the at least one rack-mounted computer equipment module and a bottom interior surface of the cabinet.

9. The system of claim 8, wherein the first baffle further defines a third air dam between the at least one rack-mounted computer equipment module and a first side interior surface of the cabinet, and a fourth air dam between the at least one rack-mounted computer equipment module and a second side interior surface of the cabinet; and optionally
wherein the first, second, third, and fourth air dams are a unitary structure.

10. A system for cooling a computer cabinet having at least two vertical rails configured to support a plurality of rack-mounted computer equipment modules which are attached to the at least two vertical rails, the system comprising:
a first baffle configured to separate an interior space of the cabinet into a first portion and a second portion, wherein the first baffle directs air flowing into the first portion of the interior space of the cabinet through the modules and to the second portion of the interior space of the cabinet.

11. The system of claim 10, further comprising a second baffle that couples the first baffle with the at least two vertical rails; or optionally wherein the at least two vertical rails comprise:
a first vertical rail disposed adjacent to a right front of the interior space of the cabinet;
a second vertical rail disposed adjacent to a right rear of the interior space of the cabinet;
a third vertical rail disposed adjacent to a left front of the interior space of the cabinet; and
a fourth vertical rail disposed adjacent to a left rear of the interior space of the cabinet; and
wherein the system further comprises a second baffle that couples the first baffle with the first and second vertical rails and a third baffle that couples the first baffle with the third and fourth vertical rails.

12. The system of claim 10 or 11, wherein the first baffle extends from a lower rear of the interior space of the cabinet to an upper front of the interior space of the cabinet, wherein the first portion of the interior space of the cabinet comprises a front portion of the cabinet, and wherein the second portion of the interior space of the cabinet comprises a rear portion of the cabinet.

13. The system of any one of claims 10-12, further comprising:
a cold air inlet vent through one of a top surface of the cabinet and a bottom surface of the cabinet; and
a hot air outlet vent through the other of the top surface of the cabinet and the bottom surface of the cabinet.

14. The system of claim 10, wherein the first baffle extends from an upper rear of the interior space of the cabinet to a lower front of the interior space of the cabinet, wherein the first portion of the interior space of the cabinet comprises a rear portion of the cabinet, and wherein the second portion of the interior space of the cabinet comprises a front portion of the cabinet.

15. The system of claim 14, wherein the first baffle defines a first air dam between the at least one rack-mounted computer equipment module and a top interior surface of the cabinet, a second air dam between the at least one rack-mounted computer equipment module and a bottom interior surface of the cabinet, a third air dam between the at least one rack-mounted computer equipment module and a first side interior surface of the cabinet, and a fourth air dam between the at least one rack-mounted computer equipment module and a second side interior surface of the cabinet.
